# EUROPEAN PATENT APPLICATION

(11) **EP 4 683 448 A1**
(43) Date of publication of application: **21.01.2026**
(21) Application number: 25190278.9
(22) Date of filing: 17.07.2025
(51) Int. Cl.: H05K 7/20

(54) **SYSTEMS AND METHODS FOR DIGITAL TWINS FOR DATA CENTER COOLING**

(30) Priority: 17.07.2024 US 202463672668 P
(71) Applicant: Hoffman Enclosures Inc., Anoka, MN 55303 (US)
(72) Inventor: Kundem, Jeshwanth Durga Sagar, Minneapolis, 55408 (US)
(74) Representative: Barker Brettell LLP

(57) **Abstract**

A system (100) for optimizing operation of CDU includes a CDU (102) to cool equipment in a data center, the CDU includes a pump (204a, 204b), a fan (202), a heat exchanger (200), and a sensor (206) monitoring operational data of the CDU. The system also includes a computing system (106) receiving real-time operational data from the sensor of the CDU and generating optimized configuration parameters for the CDU based on data from the sensor. Additionally, the system includes a digital twin (104) of the CDU hosted on the computing system, the digital twin including a physics-based model and an artificial intelligence model used to simulate thermal behavior of the CDU based on the real-time operational data from the sensor, the artificial intelligence model being trained on historical operational data from the sensor of the CDU. The system further includes a user interface (800) for interacting with the digital twin, the user interface hosted on the computing system.

## Description

### CROSS-REFERENCE TO RELATED APPLICATIONS

This application claims the benefit of U.S. Provisional Patent Application Serial No. 63/672,668, filed July 17, 2024, the content of which is hereby incorporated by reference in its entirety.

### BACKGROUND

Cooling systems can be provided for electrical equipment within data centers. Increasingly, data centers can employ a variety of cooling methods tailored to specific workloads and performance requirements. For example, data centers can utilize air cooling, liquid cooling, multi-phase refrigeration-based cooling, immersion cooling, etc. to cool electrical equipment. Infrastructure and cooling units can be provided to cool electrical equipment, and can include any combination of heat exchangers, fans, liquid pumps, sensors, flow control valves, filtration systems, etc.

### SUMMARY

According to one aspect of the present disclosure, a system for optimizing operation of a coolant distribution unit (CDU) can include a CDU to cool electrical equipment in a data center. The CDU can have a pump, a fan, a heat exchanger, and a sensor monitoring operational data of the CDU. The system can include a computing system that receives real-time operational data from the sensor of the CDU and generates optimized configuration parameters for the CDU based on real-time operational data from the sensor. The system can further include a digital twin of the CDU hosted on the computing system. The digital twin can include a physics-based model and an artificial intelligence model used to simulate thermal behavior of the CDU based on the real-time operational data from the sensor, with the artificial intelligence model being trained on historical operational data from the sensor of the CDU. The system can also include a user interface for interacting with the digital twin, hosted on the computing system.

In some examples, the physics-based model can include at least one of a stress model, a vibration model, a thermal model, a data-driven model, or a reliability model.

In some examples, the digital twin can receive operational data from the CDU and update the physics-based model based on the operational data.

In some examples, the user interface can receive input values for operating parameters of the CDU and generate outputs based on the input values using the digital twin.

In some examples, the outputs can include at least one of predicted system parameters, failure conditions, or optimized configurations for the CDU.

In some examples, the digital twin can generate an optimization strategy for the CDU based on the optimized configurations.

In some examples, the CDU can be one of a liquid-to-air CDU, a liquid-to-liquid CDU, an air-to-liquid CDU, a rear-door CDU, or an in-rack CDU.

According to another aspect of the present disclosure, a method for optimizing operation of a coolant distribution unit (CDU) in a data center can include providing a CDU including a pump, a fan, a heat exchanger, and a sensor monitoring operational data of the CDU. The method can include receiving, at a digital twin of the CDU, real-time operational data from the sensor of the CDU, the operational data including temperature data, pressure data, and flow rate data. The method can further include simulating, using a plurality of physics-based models and at least one artificial intelligence model of the digital twin, thermal behavior of the CDU based on the real-time operational data. The method can also include generating, based on the simulated behavior, control parameters for at least one of the pump or the fan to optimize cooling efficiency of the CDU.

In some examples, the digital twin can include a plurality of models to simulate behavior of the CDU, the plurality of models including at least one of a stress model, a vibration model, a thermal model, a data-driven model, or a reliability model.

In some examples, the method can include receiving operational data from the sensor of the CDU and updating one or more models of the digital twin based on the operational data.

In some examples, the method can include displaying, via a user interface, a three-dimensional image of the CDU that provides a real-time simulation of air flow within the CDU based on the real-time operational data.

In some examples, the method can include displaying, via a user interface, an operational status of the CDU, and displaying, via the user interface, an alert corresponding to detected or simulated failure conditions.

In some examples, the method can include displaying, via a user interface, selectable failure scenario options that, when selected, cause the digital twin to simulate behavior of the CDU under the selected failure scenario and display corresponding changes to operational parameters.

In some examples, the selectable failure scenario options can include at least one of pump failure, fan failure, filter clog, detected leak, loss of suction pressure, sensor failure, over-pressure, or power supply failure.

In some examples, the CDU can be one of a liquid-to-air CDU, a liquid-to-liquid CDU, an air-to-liquid CDU, a rear-door CDU, or an in-rack CDU.

According to yet another aspect of the present disclosure, a system for optimizing operation of a coolant distribution unit (CDU) can include a CDU to cool electrical equipment in a data center, the CDU including a pump, a fan, and a heat exchanger. The system can include a digital twin of the CDU, the digital twin including a plurality of physics-based models and at least one artificial intelligence model used to simulate thermal behavior of the CDU, the artificial intelligence model being trained on historical operational data from the CDU. The system can further include a computing system hosting the digital twin and providing a user interface for interacting with the digital twin. The computing system can be configured to receive real-time operational data from the CDU, generate, using the digital twin, simulated behavior of the CDU based on the real-time operational data, and display, via the user interface, the simulated behavior of the CDU.

In some examples, the plurality of physics-based models can include at least one of a stress model, a vibration model, a thermal model, a data-driven model, or a reliability model.

In some examples, the user interface can display a plurality of graphs showing real-time changes in output values including at least one of load, supply temperature, liquid flow rate, external pressure, or efficiency based on the simulated behavior.

In some examples, the user interface can display a three-dimensional image of the CDU that provides a real-time simulation of air flow within the CDU based on the real-time operational data.

In some examples, the user interface can display selectable failure scenario options that, when selected, cause the digital twin to simulate behavior of the CDU under the selected failure scenario.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the system or any device described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a diagrammatic illustration of a system for using digital twins for cooling equipment within a data center, according to aspects of the present disclosure;
FIG. 2 is a diagrammatic view of an example of high-density liquid cooling equipment for use within the data center of FIG. 1;
FIG. 3 is a diagrammatic view of a piece of cooling equipment for use with the digital twin of FIG. 1;
FIG. 4 is a diagrammatic view of a controller for computer systems of the system for providing digital twins of FIG. 1;
FIG. 5 is a diagrammatic view of electrical and control aspects of a liquid cooling unit for use in the digital twin of FIG. 1;
FIG. 6 is a diagrammatic view of a system for using digital twins for cooling equipment within the data center of FIG. 1;
FIG. 7 is a flowchart showing a process for deploying a digital twin for cooling equipment of the data center of FIG. 1; and
FIG. 8 is an illustration of a user interface for the digital twin of the data center of FIG. 1.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Similarly, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of" (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Also as used herein, unless otherwise limited or defined, the terms "about" and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. **In** contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. **In** some cases, a lateral direction can be a radial or other perpendicular direction relative to a reference direction.

Also as used herein, unless otherwise defined or limited, the term "substantially identical" indicates components or features that are manufactured to the same specifications (e.g., as may specify materials, nominal dimensions, permitted tolerances, etc.), using the same manufacturing techniques. For example, multiple parts stamped from the same material, to the same tolerances, using the same mold may be considered to be substantially identical, even though the precise dimensions of each of the parts may vary from the others.

Artificial intelligence models referenced herein may be gradient boosting models, random forest models, neural networks (NN), regression models, logistic regression models, decision tree models, Naive Bayes models, or machine learning algorithms (MLA). An MLA or a NN may be trained from a training data set. MLAs include supervised algorithms (such as algorithms where the features/classifications in the data set are annotated or "labeled") using linear regression, logistic regression, decision trees, classification and regression trees, Naive Bayes, nearest neighbor clustering; unsupervised algorithms (such as algorithms where no features/classification in the data set are annotated) using Apriori, means clustering, principal component analysis, random forest, adaptive boosting; and semi-supervised algorithms (such as algorithms where an incomplete number of features/classifications in the data set are annotated) using generative approach (such as a mixture of Gaussian distributions, mixture of multinomial distributions, hidden Markov models), low density separation, graph-based approaches (such as mincut, harmonic function, manifold regularization), heuristic approaches, or support vector machines. NNs include conditional random fields, convolutional neural networks, attention based neural networks, deep learning, long short term memory networks, or other neural models.

While MLA and neural networks identify distinct approaches to machine learning, the terms may be used interchangeably herein. Thus, a mention of MLA may include a corresponding NN or a mention of NN may include a corresponding MLA unless explicitly stated otherwise. Some MLA may identify features of importance and identify a coefficient, or weight, to them. The coefficient may be multiplied with the occurrence frequency of the feature to generate a score, and once the scores of one or more features exceed a threshold, certain classifications may be predicted by the MLA. A coefficient schema may be combined with a rule based schema to generate more complicated predictions, such as predictions based upon multiple features. For example, ten key features may be identified across different classifications. A list of coefficients may exist for the key features, and a rule set may exist for the classification. A rule set may be based upon the number of occurrences of the feature, the scaled weights of the features, or other qualitative and quantitative assessments of features encoded in logic known to those of ordinary skill in the art. In other MLA, features may be organized in a binary tree structure. For example, key features which distinguish between the most classifications may exist as the root of the binary tree and each subsequent branch in the tree until a classification may be awarded based upon reaching a terminal node of the tree. For example, a binary tree may have a root node which tests for a first feature. The occurrence or non-occurrence of this feature must exist (the binary decision), and the logic may traverse the branch which is true for the item being classified. Additional rules may be based upon thresholds, ranges, or other qualitative and quantitative tests.

The following discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

When electrical equipment (e.g., servers, network equipment, batteries, storage nodes and disks, etc.) is operated, the equipment can generate excess heat (e.g., waste heat). Overheating of electrical equipment can result in degradation of components of the electrical equipment, and in some cases, can cause damage or reduce a lifespan of the electrical equipment. Cooling systems can therefore be provided for electrical equipment to maintain the electrical equipment at safe temperature ranges (e.g., at a temperature or within a temperature range that prevents heat-induced damage to the electrical equipment). As a specific example, in a data center context, electrical equipment can include servers, which can generate a heat when performing computing workloads. Servers, and other computing equipment (e.g., power supply and power storage components, network switches and routers, storage drives, storage disks, etc.), can be provided in high-density arrangements within a data center, and can maximize a computing capacity within a space constraint of the data center. The servers and other computing equipment can be arranged within racks of the data center (e.g., in a stacked arrangement), which, in turn, can be arranged in rows within the data center.

Cooling systems can be provided for electrical equipment within a data center, to prevent an over-heating of the electrical equipment. **In** some cases, equipment within a data center can be cooled using air cooling (e.g., by providing a flow of cool air across electrical equipment and removing heated air from the data center). Increasingly, advances in computing technology allow for greater computing capacity (e.g., higher-powered central processing units (CPU), graphics processing units (GPU), or other computing chips) within a given volume (e.g., a server chassis). **In** some cases, a cooling capacity or density (e.g., amount of cooling per a given footprint in a data center) can be increased through the use of liquid-based or hybrid cooling systems. For example, servers and other cooling equipment can be cooled via a liquid cooling (e.g., via a direct-to-chip liquid cooling system), immersion cooling, multi-phase refrigeration cycles, air-to-liquid cooling, liquid-to-air cooling, etc.

Cooling infrastructure can be provided to implement cooling of computing equipment. For example, coolant distribution units (CDUs) or heat rejection units (HRUs) can include any or all of heat exchangers, air flow components (e.g., fan assemblies), fluid flow components (e.g., pumps, valves, etc.), sensors (e.g., temperature sensors, pressure sensors, flow sensors, humidity sensors, Hall sensors, etc.). CDUs and HRUs can be provided in dedicated racks (e.g., "in-row CDUs") or can be mountable within a rack of electrical equipment (e.g., "in-rack CDUs"). Further, CDUs and HRUs can be provided for liquid-to-liquid heat exchange, liquid-to-air heat exchange, refrigeration-based heat exchange, immersion cooling, etc. In some cases, cooling systems can include alternative or additional components to CDUs and HRUs, including, for example, air-to-liquid cooling unit (e.g., for transferring heat from a heated air to a chilled fluid from a facility supply), pumping units, filtration and fluid processing units (e.g., racks of filtration elements), rear-door cooling units, etc.

In some examples, it can be advantageous to provide digital twins for cooling infrastructure (e.g., any of, or any combination of in-row CDUs, in-rack CDUs, chilling units, pumping units, liquid-to-air cooling units, rear-door cooling units), as can reduce a management overhead for cooling infrastructure, provide for predictive modeling, allow for assessment of the equipment under various operating conditions, enhance a monitoring of the cooling infrastructure, allow for development of tailored models for given environments, etc.

Some examples of the discussion below describe digital modeling of physical cooling infrastructure within a data center, including the use of "digital twins" for physical cooling infrastructure. As used herein, a "digital twin" means a software representation of a physical item (e.g., coolant distribution units, pumps, heat exchangers, rear-door cooling units, etc.). A digital twin can be a model that is configured to mimic an aspect of the corresponding physical item. For example, a digital twin can include a structural model of a CDU or HRU and can provide a simulation of stresses on the mechanical components of the CDU or HRU under different load conditions. As discussed further below, a digital model, according to examples of the disclosure can also include models for other aspects of an item, including fluid flow models, thermal models, electrical models, vibration models, etc. In some cases, models included in a digital twin can be trained artificial intelligence models that can be trained to simulate a behavior of components or systems of a CDU or HRU. Embodiments of the disclosed systems and methods can be used in other contexts, such as for cooling equipment other than servers, or various other electronics, configured in various ways, including with other shapes and arrangements of elements. While the discussion below is provided in the context of a data center, the disclosed systems and method can be used for cooling outside of a data center, including, for example, in edge computing location.

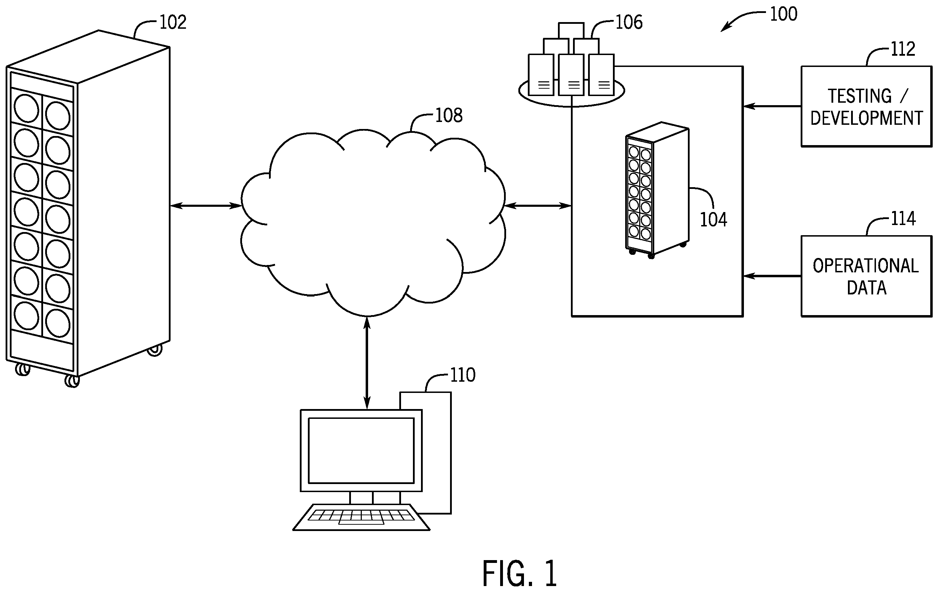

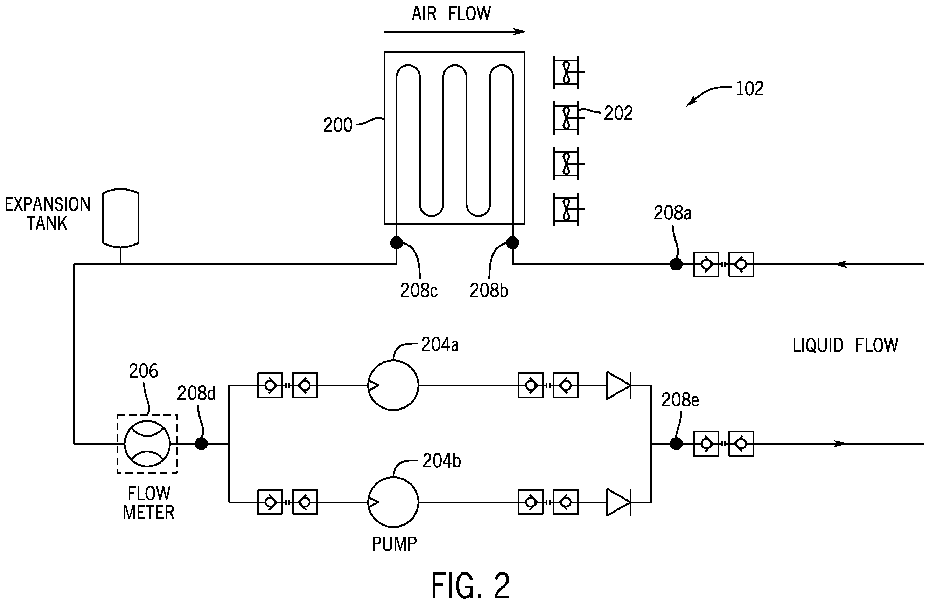

FIG. 1 illustrates an example of a system 100 including a piece of cooling equipment (e.g., a CDU or a HRU 102) and a digital twin 104 (e.g., a software-based model of the CDU or HRU 102) for the CDU or HRU 102. In some examples, the CDU or HRU 102 may be an in-row liquid-to-air CDU or HRU, configured to provide a flow of coolant to electrical equipment to be cooled. For example, as discussed further with respect to FIG. 2, the CDU or HRU 102 can include a rack that can have housed therein a liquid-to-air heat exchanger (LTA HX). Pumps of the CDU or HRU 102 can pump a liquid coolant through the LTA HX, and through a liquid cooling circuit including electrical equipment to be cooled. The CDU or HRU 102 shown further includes fans to provide a flow or air across the LTA HX to affect a desired cooling of the liquid coolant flowing through the LTA HX. While the CDU or HRU 102 described herein is an in-row LTA CDU or HRU, the discussion of the present disclosure is equally applicable to other cooling infrastructure. For example, a system for using a digital twin can include an in-row liquid-to-liquid (LTL) CDU or HRU, an in-rack LTA CDU, chillers, rear-door cooling units, reservoir pumping units (RPUs), etc. In some examples, digital twins can be provided for systems including multiple individual cooling units. For example, a cooling circuit can include multiple rear-door cooling units and RPUs, and a digital twin can be provided for the cooling circuit including a composite model of the system as a whole (e.g., including models for reach of the rear-door cooling units and RPUs).

The CDU or HRU 102 may be powered using an alternating current (AC) power source, such as a three-phase wye or delta source. In some examples, the CDU or HRU 102 can further include a shelf to house one or more power supply units (PSUs) configured to convert power received from the AC power source into direct current (DC). The DC power may be distributed from the one or more power supply units to components within the CDU or HRU 102, as described herein. In some examples, the CDU or HRU 102 includes an N+N redundancy power shelf, configured to house multiple PSUs. However, in some examples, only a portion of the PSUs is actively being used to power the CDU or HRU 102. For example, the CDU or HRU 102 may house six total PSUs, with only three of the PSUs powering the CDU or HRU 102 at a given time. If one of the three PSUs powering the CDU or HRU 102 fails, one of the remaining three PSUs may start-up and take over for the failed PSU.

As shown in FIG. 2, the CDU or HRU 102 includes a liquid-to-air heat exchanger 200 (LTA HX), fans 202, a flow meter 206 (e.g., a sensor for sensing a fluid flow rate through the CDU or HRU 102), and redundant pumps 204a, 204b. A liquid coolant can flow from an inlet through the LTA HX 200 and can continue to flow through the flow meter 206, and can be pumped to downstream equipment through one or both of the pumps 204a, 204b. The fans 202 can produce an air flow across the LTA HX 200 to increase a transfer of heat from the liquid coolant to the air at the LTA HX 200. Further, sensor modules 208 can be provided along the flow path of fluid through the CDU or HRU 102 (e.g., one or both of a flow path of liquid coolant and air). The sensor modules 208 can include one or both of a temperature sensor and a pressure sensor for the liquid coolant flowing through the CDU or HRU 102. In the illustrated example, the sensor modules 208 include an inlet sensor module 208a, an outlet sensor module 208e, a sensor module 208b immediately upstream of the LTA HX 200, a sensor module 208c immediately downstream of the LTA HX 200, and a sensor module 208d immediately upstream of the pumps 204a, 204b. In other examples, a cooling unit can include more or fewer sensor modules, and sensor modules can be differently arranged along a fluid flow path. Measured values from the sensor modules 208 can be used to implement control procedures for the CDU or HRU 102. For example, proportional-integral-derivative (PID) controllers implemented by a control system of the CDU or HRU 102 can be configured to control an operation of the pumps 204a, 204b and the fans 202 to achieve a desired outlet temperature at any of module 208c, 208d, 208e.

In some cases, sensors and sensor modules can provide redundancy and failover capacity in the event of a failure of another sensor module. The sensor modules 208 can continually gather measurements, and those measurements can be monitored and analyzed, as described below, to perform diagnostics and troubleshooting, optimize a performance of the CDU or HRU, and provide predictive capabilities for the CDU or HRU 102. In some cases, sensors can be provided at the fans 202 (e.g., humidity sensors, temperature sensors, flow rate sensors, pressure sensors, etc.) and measurements obtained from the sensors can further be used to operate the CDU or HRU 102 (e.g., to implement PID controls, generate alerts, provide historical data, etc.). While FIG. 2 illustrates an LTA CDU or HRU 102, the teaching of this disclosure is equally applicable for other cooling infrastructure including, for example, liquid-to-liquid CDUs and HRUs, chillers, rear-door cooling units, RPUs, etc.

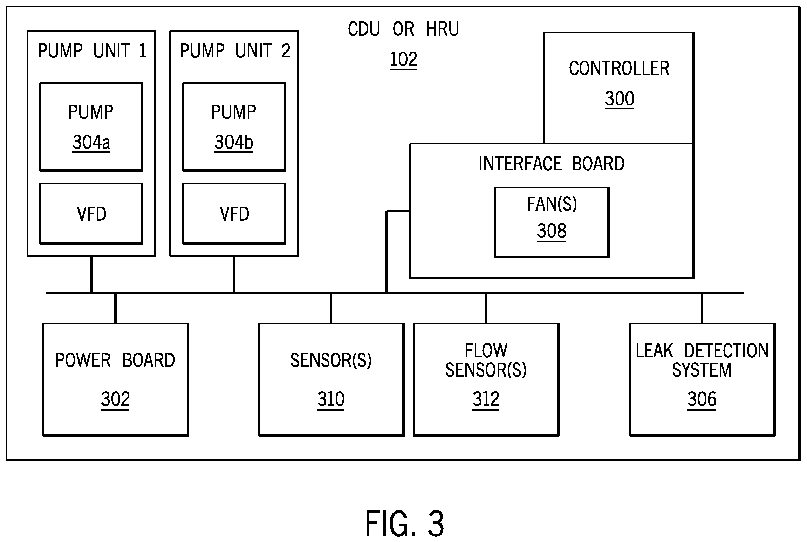

Cooling infrastructure within a data center (e.g., the CDU or HRU 102) can further include electrical and control systems for operating the respective infrastructure. With continued reference to the LTA CDU or HRU 102, FIG. 3 illustrates a diagrammatic view of the CDU or HRU 102, illustrating communication between elements of the LTA CDU or HRU 102. As shown, the LTA CDU or HRU 102 includes a controller 300, a power board 302, pumps 304a, 304b (e.g., the control aspects for the pumps 204a, 204b shown in FIG 2), fans 308, a leak detection system 306, sensors 310, and a flow sensor 312.

As shown, each of the electrical components of the LTA CDU or HRU 102 are in communication with the controller 300. For example, the sensors 310, 312 can provide measurement values to the controller 300, and the controller 300 can issue command signals to the pumps 304a, 304b and the fans 308 to increase a speed, decrease a speed, change an operating mode, etc. In some cases, the controller 300 can provide a user interface (UI) (e.g., through a wired or wireless connection) to permit an operator to view operational parameters of the LTA CDU or HRU 102 and to control an operation thereof. In some examples, electrical systems of an LTA CDU or HRU can include additional elements controllable by a controller. For example, a fill pump can be provided to inject a fluid into a liquid cooling circuit upon a determination that a pressure is reduced within the circuit. In some cases, power supply units can be operated in various modes in response to communications from a controller. In some cases, a cooling unit can operate in an autonomous mode when a controller is removed (e.g., local controllers for any or all of pumps 304a, 304b and fans 308 can operate the respective elements according to predefined behaviors when a communication with the controller 300 is interrupted or lost).

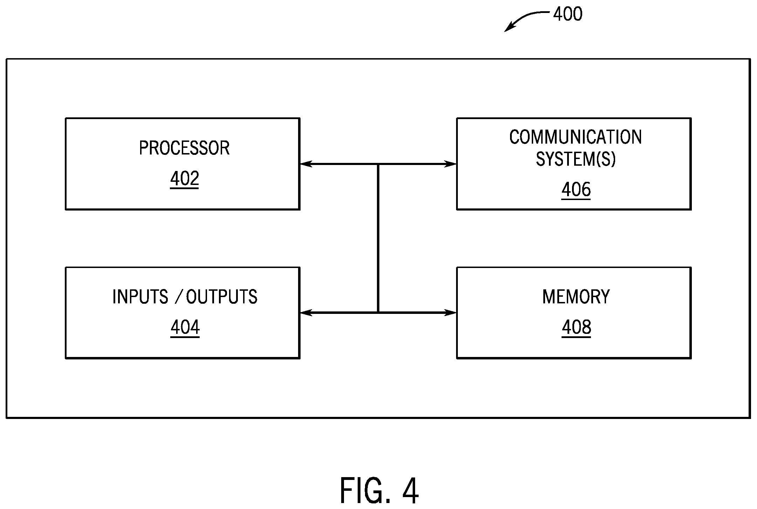

FIG. 4 illustrates an example controller 400, of which the controller 300 can be an instance or a variant. In some embodiments, the controller 400 can be a programmable logic controller (PLC). In some embodiments, the controller 400 can include a processor 402, one or more input/output interfaces 404, a communication system(s) 406, and a memory 408. In some examples, the processor 402 can be any suitable hardware processor or combination of processors, such as a central processing unit (CPU), a graphics processing unit (GPU), an application specific integrated circuit (ASIC), a field-programmable gate array (FPGA), etc. In some examples, one or more input/output interfaces 404 can include any suitable display device, such as a computer monitor, a touchscreen, a television, any suitable input devices and/or sensors that can be used to receive user input, such as a keyboard, a mouse, a touchscreen, a microphone, a camera, etc. In some cases, inputs can be received at a display which can present a user interface through which an operator can view system parameters, and set control parameters (e.g., set an operating mode, define set points for temperature or pressure, set a language of the system, etc.). In some cases, an input/output interface 404 can be an API, a CLI, a wired interface, etc.

In some examples, the communication system(s) 406 of the controller 400 can include any suitable hardware, firmware, and/or software for communicating information over any suitable communication networks. For example, the communication system(s) 406 can include one or more transceivers, one or more communication chips and/or chip sets, etc. In a more particular example, the communications system(s) 406 can include hardware, firmware and/or software that can be used to establish a Wi-Fi connection, a Bluetooth connection, a cellular connection, an Ethernet connection, etc. In some examples, inputs can be received at the controller 400 through the communication system(s) 406 (e.g., over a communication network). For example, the controller 400 can be a controller of a cooling unit (e.g., controller 300 shown in FIG. 3) an application programming interface, command line interface, or web interface can be provided for a liquid-to-air cooling unit to allow an operator to control the liquid-to-air cooling unit remotely.

In some examples, the memory 408 can include any suitable storage device or devices that can be used to store instructions, values, etc., that can be used, for example, by the processor 402 of the controller 400 to implement control loops and algorithms, to store logs of the controller 400, etc. The memory 408 can include any suitable volatile memory, non-volatile memory, storage, or any suitable combination thereof. For example, the memory 408 can include random access memory (RAM), read-only memory (ROM), electronically-erasable programmable read-only memory (EEPROM), one or more flash drives, one or more hard disks, one or more solid state drives, one or more optical drives, etc. In some examples, the memory 408 can have encoded thereon a computer program for controlling operation of the controller 400.

A digital twin can be provided for cooling infrastructure within a data center. Digital twins can comprise a digital representation of a physical unit that can model a behavior of the physical unit. In some cases, a digital twin can comprise one or more artificial intelligence models that can be developed based on design characteristics of the physical unit, and can be trained on training data to ensure that a simulated behavior of a digital twin is similar or identical to a behavior of the physical unit. In the illustrated example, the digital twin 104 is a digital model of an in-row LTA CDU or HRU, having similar characteristics (e.g., identical characteristics) as the LTA CDU or HRU 102.

The digital twin 104 can comprise multiple models of aspects of the LTA CDU or HRU 102. For example, the digital twin 104 can include a mechanical model of the LTA CDU or HRU 102 including defined dimensions of the frame, materials of the CDU or HRU 102, connection points, etc. The mechanical model included in the digital twin 104 can allow a modeling of a mechanical behavior of the CDU or HRU 102 based on known physics of the materials and structure of the CDU or HRU 102 (e.g., the digital twin can include physics-based models that can operate based on a digital definition of the CDU or HRU 102). A physics-based model of a CDU or HRU 102 can be based on a three-dimensional computer-aided design (CAD) model of the CDU or HRU 102 in which materials, a structure, and connection interfaces (e.g., welds, fasteners, interlocking components, fluid connections) are defined. In some cases, as described below, an operator of a CDU or HRU (e.g., the CDU or HRU 102) can use a physics-based model to predict a mechanical behavior of the CDU or HRU, predict failure of components, plan maintenance activities, model prospective scenarios based on various potential operating conditions, etc.

A digital twin can include models for various components and characteristics of corresponding cooling infrastructure, additionally or alternatively to a structural model. In some examples, a physics-based model can be provided to model a heat transfer at one or more points along a cooling infrastructure. For example, a model may use an epsilon-number of transfer units (NTU) methodology to model the behavior of the heat exchanger. In particular, the epsilon-NTU methodology may utilize data collected from a heat exchanger placed in an air tunnel and operated in various conditions. In further examples, a neural network may be employed to model the behavior of a heat exchanger. For example, the heat exchanger may be divided into N-segments to create an initial model. Each segment may correspond to a three-dimensional control volume where heat is transferred between air and water. The model may generate a sequence of datapoints based on the initial model, which represents a spectrum of operating conditions for every data point. A neural network can receive the sequence of datapoints as an input, as well as corresponding parameters such as a liquid supply temperature, a liquid mass flow, and an air inlet temperature. In some examples, the neural network may include a first layer with 32 nodes, a second layer with 64 nodes, and a third layer with 64 nodes.

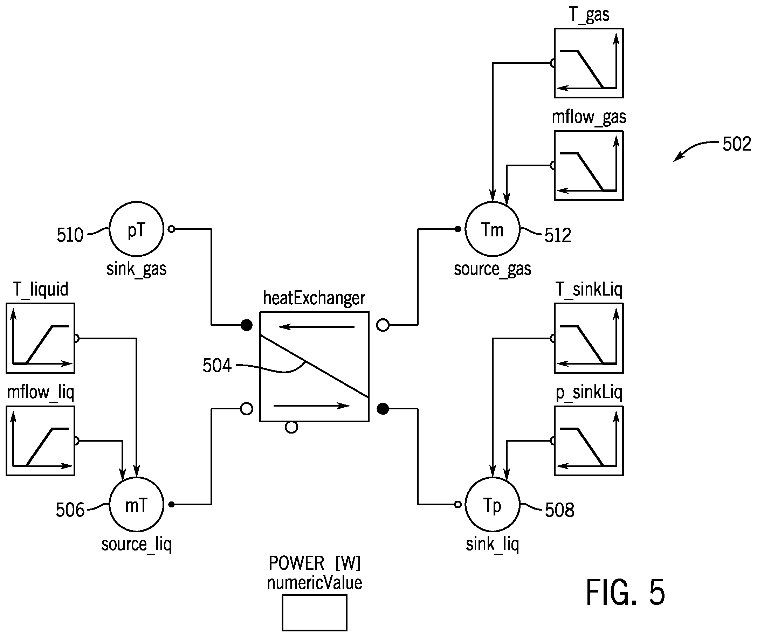

FIG. 5 illustrates a model 502 for a heat exchanger (e.g., heat exchanger 200 shown in FIG. 2), which, as mentioned, can be a physics-based model (e.g., can model a behavior of the heat exchanger based on known physical characteristics, materials, and configuration of the heat exchanger according to physics-based rules). In the illustrated example, the heat exchanger model simulates an LTA HX 504, with a liquid coolant flowing through the LTA HX 504 and transferring a heat to a fluid (e.g., air) flowing across the LTA HX 504. As shown, inputs can be defined for any or all of a fluid inlet (mT) 506, a fluid outlet (Tp) 508, an air inlet (pT) 510, and an air outlet (Tm) 512. For example, in the example shown, an input at the fluid inlet can include a mass flow of fluid over time and an inlet temperature of the fluid over time.

In some cases, inputs can comprise schedules for operating parameters that can be based on known usage parameters and peak usage times for the cooling units. Additional inputs shown include a pressure of a fluid at the fluid outlet over time, a temperature of the fluid at a fluid outlet over time, a temperature of a gas at the air inlet over time, and a mass flow rate of the gas at the air inlet over time. The model can calculate parameters of the gas at the air outlet based on the inputs received. The model can also calculate a heat transfer rate based on known configuration of the LTA HX 504 and the inputs. In some cases, more or fewer inputs can be provided. The example provided is not intended to be limited, but is an example of a model of a component of a cooling unit (e.g., the CDU or HRU 102) that can be included in a digital twin. For example, the digital twin 104 can include mechanical, electrical, and flow models for one or more pumps 204a, 204b and fans 202 (e.g., shown in FIG. 2), plumbing arrangements of the CDU or HRU 102, etc.

As mentioned above, the digital twin 104 may include a model corresponding to a reservoir pump unit (RPU). In some examples, the RPU may be a pump integrated into a subassembly including one or more pumps, plumbing components, tubes, etc. The RPU may include four control modes: a manual mode, a liquid flow mode, an external pressure mode, and a temperature differential mode. For example, in manual mode, a user may specify a pump speed of the RPU. Moreover, in the liquid flow mode, the external pressure mode, and the temperature differential mode, the user may enter a desired flow rate, delta pressure, and temperature difference between a return and a supply, respectively. The RPU model may employ a proportional integral derivative (PID) loop. The RPU model may determine a ratio of fluid power to electric power based on parameters such as liquid flow rate, pressure, head, and rotations per minute (RPM) of the RPU.

In some cases, a digital twin 104 can include models for additional components, such as one or more PSUs. In some examples, the digital twin 104 can calculate a power draw of each power consumption unit (e.g., pumps, fans, etc.) connected to the CDU or HRU 102. In some examples, the one or more fans may operate using a manual control mode and a liquid supply temperature control mode. When operating in the manual control mode, a user may specify a fan speed (e.g., an RPM). Moreover, when operating in the liquid supply temperature control mode, a user may specify a required supply temperature. The digital twin 104 may include a model that utilizes computational fluid dynamics, fan power requirements, and fan power quality (PQ) curves to model the behavior of one or more fans within the PSU operating in any control mode.

In further examples, the digital twin 104 may compare an input power provided to the one or more PSUs to a combined power draw of each power unit to output a coefficient of performance or efficiency of the unit to an end user. The digital twin 104 can utilize second order polynomial equations to determine a power consumed by a pump, as well as measure the operating characteristics of the pump, such as pressure and liquid flow. In some examples, the digital twin 104 can include a flow rate of the LTA HX 504 flow rate.

In some cases, a digital twin for cooling infrastructure (e.g., one or more cooling units) can comprise one or more trained artificial intelligence models. For example, a model can be trained on operational data (e.g., historical measurements received from sensors of a CDU or HRU, such as sensor modules 208, flow meter 206 shown in FIG. 2, etc.). An artificial intelligence model can be data driven and can provide predictive capabilities based on a volume of training data. In some cases, an artificial intelligence model can supplement or augment physics based models. For example, a physics-based model can differ from a physical product due to variations in tolerances, or other variations of a CDU or HRU from the defined parameters of the physics-based model. In some cases, a performance of a CDU or HRU can be compared to a predicted performance from a physics-based model and when a performance differs from the physics-based model, the physics-based model can be tuned to accurately model the CDU or HRU (e.g., through a machine-learning training process). In some cases, a digital twin can comprise a trained artificial intelligence model configured to provide predictions of an output (e.g., a mechanical output, a component behavior, an electrical configuration, etc.) for the system based on input parameters. For example, the digital twin 104 can receive as input an ambient air temperature and a return temperature of a liquid coolant, and can generate an operational configuration (e.g., a fan speed, pump speed, defined PID control gains, etc.) to meet desired performance characteristics (e.g., a temperature differential, a pressure differential, a flow rate, etc.) given operational constraints (e.g., maximum and minimum values for any of temperature, pressure, flow rate, etc.).

Training, developing, and operating software including digital twin models can require significant computing resources. In some cases, a digital twin can be hosted (e.g., stored and operated) on a computer system including one or more computing devices (e.g., servers, computers, storage disks and drives, network switches and routers, etc.). In the illustrated example, the digital twin 104 is stored on a computing system 106. In some cases, the computing system 106 can comprise a server. In some cases, the computing system 106 can be a distributed computing system including a plurality of servers. In some cases, the computing system 106 can be a cloud computing environment. In the illustrated example, the computing system 106 is remote from the LTA CDU or HRU 102 (e.g., the infrastructure hosting the computing system 106 is housed in a facility other than the data center in which the LTA CDU or HRU is housed).

The computing system 106 can include one or more computing elements. For example, servers of the computing system 106 can include a processor, a communications system, input/output devices, and memory. In some cases, the computing system can include virtual machines, or containerized modules hosted on distributed infrastructure. The computing system 106 can provide an interface (e.g., an API, a user interface (UI), a web interface, a CLI, a wired interface, etc.) to allow an operator or other computing systems to interact with the digital twin 104 stored thereon.

In some cases, inputs can be provided to a computing system to develop, update, and maintain a digital twin. For example, the computing system 106 can receive a testing/development input 112 (e.g., from other computing systems) to define or refine the digital twin 104. For example, an updated physical model for the digital twin 104 can be provided that can provide additional definition to the digital twin (e.g., a CAD model can be updated with materials of the CDU or HRU 102, surface textures, or other granular details not included in a previous version of the digital twin 104). In some case, software bugs and vulnerabilities can be identified in a testing and development process, and patches and software updates can be deployed.

Further, a computing system hosting a digital twin (e.g., the computing system 106 hosting the digital twin 104) can receive operational data as can further train and refine the model. For example, the computer system 106 can receive a feed of sensed data from CDUs and HRUs (e.g., similar to the CDU or HRU 102) in a test environment, or CDUs and HRUs deployed in operation within data centers. The operational data can be used to implement a training and validation process through which artificial intelligence models of the digital twin 104 can be refined (e.g., fine-tuned) to provide more accurate diagnostic and predictive capabilities.

As shown, the system 100 can further include a computing system 110. The computing system 110 can be a personal computer, a tablet, a mobile phone, a virtual computer (e.g., a software-defined device), etc. The computing system 110 can be a device through which a user can communicate with one or both of the LTA CDU or HRU 102 (e.g., or other cooling infrastructure) and the computing system 106 and digital twins 104 hosted thereon. For example, either or both of the LTA CDU or HRU 102 and the computing system 106 can provide an interface through which to read data from or provide commands to the CDU or HRU 102 and computer system 106, respectively. In some cases, an interface of one or both of the CDU or HRU 102 and the computer system 106 can include a web interface, an application programing interface (API), a command line interface (CLI) or any other interface as can allow a computing system110 to communicate with cooling infrastructure or software and infrastructure hosting digital twins of the cooling infrastructure.

In the illustrated example, communication between any of the LTA CDU or HRU 102 (e.g., a control system of the LTA CDU or HRU 102), the computing system 106, and the computing system 110 can occur through a communications network 108. In some examples, the communications network 108 can include any suitable hardware, firmware, and/or software for communicating information digitally between computing systems 110, 106 and a control system of the CDU or HRU 102. For example, the communications network can include hardware, firmware and/or software that can be used to establish a Wi-Fi connection, a Bluetooth connection, a cellular connection, an Ethernet connection, etc. In some cases, devices (e.g., computing systems 106, 110, and a controller of the CDU or HRU 102) can communicate over a wired connection (e.g., through a USB connection, an ethernet cable, etc.).

In some cases, networked devices (e.g., a controller of the CDU or HRU 102, the computing systems 106, 110, etc.) can communicate with all or a portion of other devices and systems included in a system (e.g., the system 100). For example, in some examples, the computing system 110 can access both of a control system (e.g., controller 300 shown in FIG. 3) of the CDU or HRU 102 and the digital twin 104. An operator can issue commands to the digital twin 104 to perform a simulation given environmental or operational parameters, and can receive data from the digital twin 104 predictive of a behavior of the CDU or HRU 102 under the specified environment or operational parameters. Further, the operator can receive a recommendation from the digital twin 104 at the computing system 110 to perform an action at the CDU or HRU 102 (e.g., replace a fan assembly, increase a pump speed, reduce a fan speed, change minimum or maximum values for operational parameters, adjust PID controller gains, etc.). The operator can issue a command to the control system of the CDU or HRU 102 through the computing system 100 (e.g., via the communications network 108) that can implement recommendations generated at the digital twin 104.

In some cases, cooling infrastructure can be operatively connected to a digital twin. For example, data from the CDU or HRU 102 (e.g., readings from sensors of the CDU or HRU 102, pump or fan speeds, fluid temperatures and pressures, failure conditions, etc.) can be provided to the digital twin 104, and can be used at the digital twin 104 to generate predictions or provide recommendations for increasing a performance of the CDU or HRU 102 or for optimizing a maintenance of the CDU or HRU 102. In some cases, data from the CDU or HRU 102 can be used to train, tune, or validate one or more models of the digital twin 104. For example, if a predicted behavior from the digital twin 104 differs from an actual behavior of the CDU or HRU 102, the digital twin 104 can be further trained to increase a predictive accuracy of the digital twin.

In some cases, the system 100 can provide a real-time integration of the CDU or HRU 102 with the digital twin 104. For example, data from sensors (e.g., sensor modules 208 shown in FIG. 2, flow meter 206 shown in FIG. 2, data from fan sensors, pump speed sensors, etc.) of the CDU or HRU 102 can be streamed to the computing system 106 (e.g., via the communications network 108). The data can be provided to the digital twin 104, and the digital twin 104 can replicate a behavior of the CDU or HRU 102 in real-time or near real-time. In some cases, a real-time integration can allow a monitoring of system parameters and can facilitate a predictive maintenance and diagnostics of the system. The digital twin 104 can provide communications (e.g., alerts, recommendations, etc.) to an operator at computing system 110 based on the data received from the CDU or HRU 102. For example, the model of the digital twin 104 can provide an indication (e.g., an alert) to a user when a pressure profile of a fluid flowing through the CDU or HRU 102 indicates a failure or degradation of performance of a pump (e.g., one of the pumps 204a, 204b). In some cases, the digital twin 104 can provide a recommendation to speed or slow pumps or fans to achieve desired cooling of the fluid coolant. A digital twin 104 can simulate various potential configurations (e.g., gains of PID controllers for pump speed or fan speed, operating modes of pumps or fans, target parameters for PID controllers, etc.) given environmental values (e.g., an air inlet temperature, a fluid inlet temperature, a humidity, etc.) and historic performance of the CDU or HRU 102, and can provide a recommendation to an operator including configuration changes to optimize a performance of the CDU or HRU 102.

In some cases, a digital twin can control operation of a corresponding physical product. For example, as noted above, the CDU or HRU 102 can provide real-time operational data to the digital twin 104, and based on an output of the digital twin 104, the computing system 106 can provide a signal to the CDU or HRU 102 to control an operation of the CDU or HRU 102. For example, the digital twin 104 can predict a failure of a pump (e.g., one of the pumps 204a, 204b) based on operational data received from the CDU or HRU can issue a command to the CDU or HRU 102 to initiate a failover process for the pumps. In some cases, as noted above, the digital twin 104 can generate an optimal configuration for the CDU or HRU 102 (e.g., an optimal operating mode, PID control parameters and speed for the pumps and fans, maximum and minimum threshold values for speeds of the pumps and fans and temperatures of the air and fluid coolant, etc.), and can issue a command to the CDU or HRU 102 (e.g., to the controller 300 shown in FIG. 3) to change the configuration to the generated optimal configuration. In some cases, the computing system 106 can issue an approval request to the computing system 110 before implementing a change at the CDU or HRU 102, and can implement the change upon a received approval at the computing system 110 from an operator.

In some cases, the system 100 can be used to perform scenario planning for a deployed CDU or HRU 102. For example, an operator can simulate a behavior of the CDU or HRU 102 at the digital twin 104 by providing various scenarios (e.g., operational parameters) to the digital twin 104 and evaluating a predicted response of the CDU or HRU 102. For example, an operator can provide operational parameters to the digital twin 104 simulating a temperature spike of an air within the data center (e.g., a failure of an air conditioning system) and can determine an optimal configuration for the CDU or HRU 102 under that condition. In some cases, a digital twin 104 can predict a failure of components of the CDU or HRU 102 under simulated conditions, and an operator can develop an action plan for the scenario based on the predicted component failure.

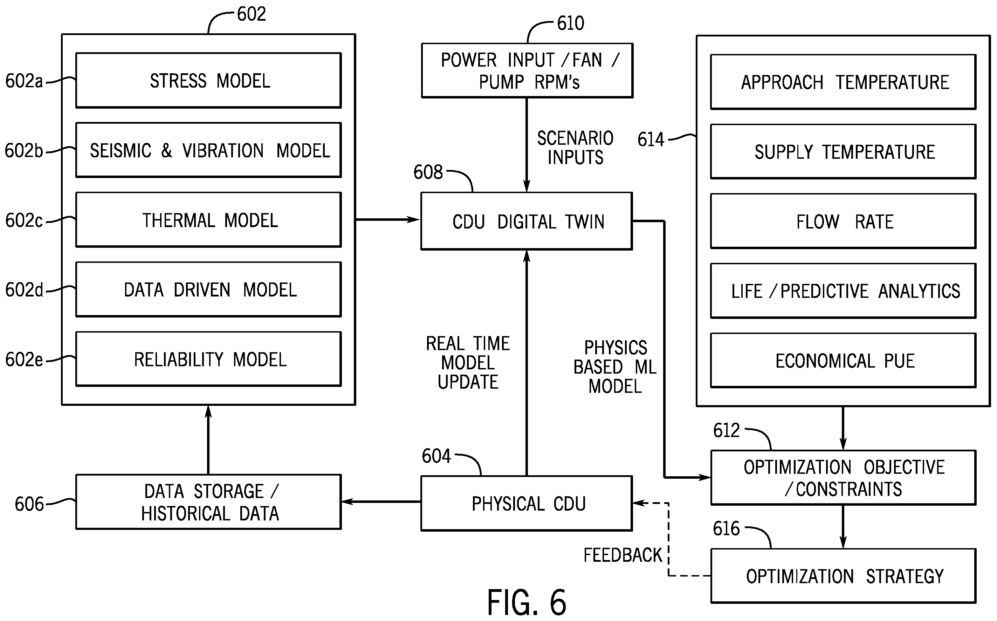

FIG. 6 illustrates another example system 600 for using digital twins to enhance operation of a data center cooling unit. As shown, a plurality of models 602 can be provided for a physical CDU or HRU 604 to model a behavior and operation of aspects of the physical CDU or HRU 604. As discussed above, models can be provided for all or a portion (e.g., the heat exchanger model 502 illustrated in FIG. 5) of a CDU or HRU. Further, models can be provided for cooling systems that include multiple cooling units (e.g., multiple CDUs and HRUs, RPUs, rear-door cooling units, air-to-liquid cooling units, chillers, etc.).

In the illustrated example, the models include a stress model 602a, a vibration model 602b, a thermal model 602c, a data driven model 602d, and a reliability model 602e. In some cases, additional models can be provided to model additional system characteristics. For example, models for a digital twin can include a power consumption model. In the illustrated example, models of the plurality of models 602 can be defined based on physical characteristics of the system. For example, the vibration model 602b can be primarily or entirely based on physical characteristics of the CDU or HRU 604 defined in a three-dimensional CAD model of the CDU or HRU 604. Further, the stress model 602a can be based on defined geometries and properties of materials of the CDU or HRU 604 as defined in the CAD model. In some cases, models can be developed based on artificial intelligence techniques and methods. For example, the data driven model 602d can identify features in data from CDU or HRU operation that can correlate to predicted outcomes. In some cases, a data-driven model can identify correlations between inputs and predicted behaviors or outcomes that are not derivable from physics-based model alone. In some cases, data-driven models of a digital twin can utilize supervised learning techniques to predict outcomes based on label inputs. In some cases, data-driven models can utilize unsupervised learning techniques to identify patterns in unlabeled data.

The thermal model 602c can be physics-based, and can predict a thermal performance of the system based on known characteristics of the flow path through the CDU or HRU 604, materials of components of the CDU or HRU 604, efficiencies of components of the CDU or HRU 604, etc.

Some or all of the models 602 can comprise physics-based models and artificial intelligence models. For example, models can be based on predefined system characteristics (e.g., materials, geometries, flow arrangements, etc.), but predictions based on those models can differ from a system behavior. A fluid outlet temperature (e.g., fluid outlet temperature measured at sensor module 208e shown in FIG. 2) can differ from a predicted outlet temperature of the thermal model 602c. The thermal model 602c can be tuned based on historic or real-time data from the data store 606 to provide a more accurate prediction of system behavior. In some cases, fine-tuning a physics-based model can include adding one or more convolutional layers downstream of an output of the physics-based model, and transforming the output at the convolutional layers to achieve an adjusted result.

The models 602 can be incorporated into a digital twin 608 of a CDU or HRU (or other cooling infrastructure) and can be used to simulate a behavior of the CDU or HRU 604 under specified conditions. The digital twin 608 can be engageable by an operator or other systems via an interface, as described above, and can generate outputs, alerts, recommendation, command signals, predictions etc. based on an input. For example, the digital twin 608 can receive as an input (e.g., via an API, a CLI, a web interface, etc.) input values 610 for operating parameters of a CDU or HRU (e.g., operational parameters obtained from the CDU or HRU 604 or simulated operating parameters input by an operator or other system). Input values can include a power input, a fan speed, a pump speed (e.g., in revolutions per minute (RPMs)), valve positions for flow control valves, operating modes for pumps (e.g., active-active, active-passive, primary-secondary, etc.) or other configurable inputs for the CDU or HRU. Further, inputs at 610 can include a selection of a target parameter for PID controllers (e.g., one of an outlet temperature, a differential temperature, an outlet pressure, a flow rate of fluid through the CDU or HRU, etc.), configurable gains for the PID controllers, etc. In some cases, an operator can provide inputs 610 to the digital twin 608 to perform scenario planning for different possible scenarios within a data center. In some cases, the inputs 610 can be obtained directly from the CDU or HRU 604 in real-time, near real-time, or as historical data to be analyzed.

The digital twin 608 can receive the inputs 610, and generate outputs (e.g., predicted system parameters, failure conditions, optimized configurations, etc.) based on the inputs 610. In some cases, outputs can comprise predefined or preselected outputs. For example, outputs of the digital twin 608 can be an outlet temperature of a fluid coolant given the inputs 610. In some cases, outputs can include predicted failures of components, optimal configuration values given the inputs 610, a servicing recommendation, etc. In some cases, a digital twin can perform optimization based on physics-based models, data driven models, and input values.

As further shown in FIG. 6, the digital twin 608 can be configured to perform an optimization 612 or solve for particular constraints given inputs 610 and operational data of the CDU or HRU 604. An optimization target (e.g., a target value for a parameter, a maximization or minimization of a parameter subject to constraints, etc.) can be provided to be optimized or calculated in the optimization 612. In some cases, the digital twin can be configured to optimize any of an approach temperature for a heat exchanger (e.g., the LTA HX 200 shown in FIG. 2), a supply temperature (e.g., a temperature at a fluid outlet of the CDU or HRU 604), a flow rate, a power usage efficiency, etc.

In some cases, an optimization strategy can be generated from an optimization performed by a digital twin. For example, as shown, optimization strategy 616 is generated from the optimization 612. An optimization strategy can include recommended values for a configuration of the CDU or HRU to achieve the optimal values for the parameters calculated in the optimization 612. In some cases, an optimization strategy can include optimized PID control values to achieve the desired result. In some cases, an optimization strategy can include an operating mode for pumps, fans, or other controllable elements (e.g., valves, refill pumps, etc.). An optimization strategy can include a recommendation to replace or service a component of the CDU or HRU 604 (e.g., a recommendation to replace a filter, to service a fan, to replace a pump, etc.).

The optimization strategy 616 can be used to control an operation of the CDU or HRU 604. In some cases, the optimization strategy can be provided to an operator (e.g., the optimization strategy can be received at computing system 110 for use by an operator in controlling an operation of the CDU or HRU 102). In some cases, the optimization strategy can be implemented directly, and a command signal or communication can be provided to the physical CDU or HRU 604 based on the optimization 612 to control a configuration of the CDU or HRU 604, an operation of pumps and fans, etc.

In some cases, the digital twin 608 can be continually trained on operational data from the CDU or HRU 604. As shown, the CDU or HRU 604 can provide a stream of data to the digital twin 608 to update the digital twin. In some cases, the data can be used in artificial intelligence algorithms to adjust one or more of the models 602. For example, if a predicted value of an operational parameter differs from an actual value of the parameter under the same conditions by a threshold about, artificial intelligence models can be trained on the operational data to better fit predicted behavior of the CDU or HRU 604 to an actual behavior of the CDU or HRU 604. In some cases, the CDU or HRU 604 can provide operational data to the digital twin 608 for training when an actual performance of the CDU or HRU 604 differs from a performance predicted by the digital twin (e.g., a predicted operational parameter is outside a range or a margin of error from the actual operational parameter).

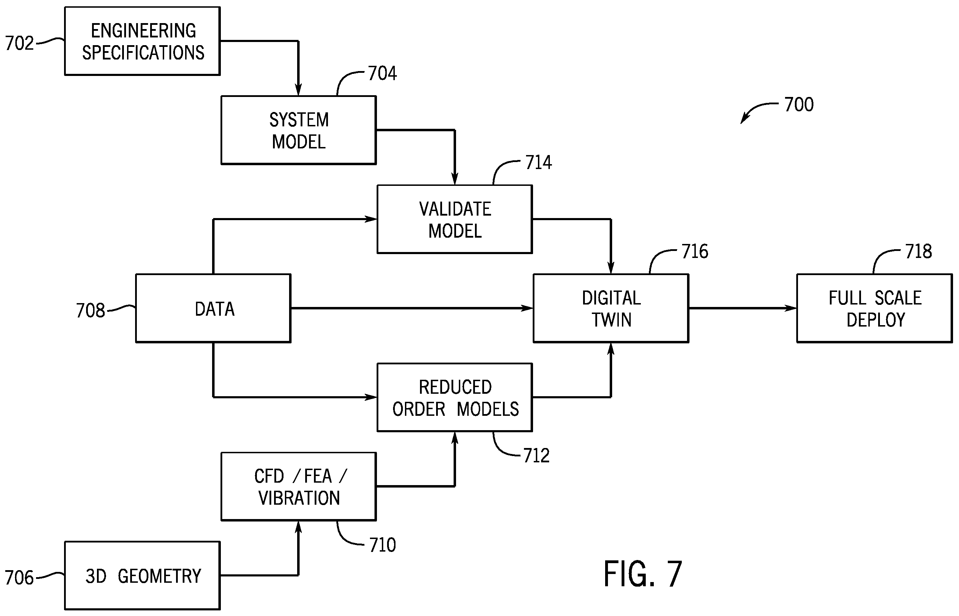

FIG. 7 illustrates a process 700 for developing and deploying a digital twin, according to some aspects of the disclosure. At block 702, engineering specifications can be received or developed. Engineering specifications can include a required cooling capacity for cooling infrastructure (e.g., a CDU or HRU) to provide cooling to a set of electrical equipment (e.g., electrical equipment housed in racks of a data center). Specifications can include a required flow rate of fluid through a cooling unit, a space constraint of the cooling unit, a minimum approach temperature for a heat exchanger, etc.

At block 704, a system model can be developed. In some cases, a system architecture can be developed to determine components of the cooling unit. For example, system components can be selected based on the engineering specifications at 702 and constraints for the system. Preparing a system model at block 704 can include selecting any of pumps, fans, heat exchangers, filters, controllers, valves, and other components of the system. In some cases, an arrangement of a heat exchanger (e.g., an orientation of the heat exchanger within a volume) can be determined as part of the system model at block 704. A plumbing arrangement can further be developed as part of the system model, including a relative positioning of components along a fluid flow path, the existence and positioning of bypass lines, etc.

A system model can provide a physics-based model, and can be tested and revised based on known historical data. For example, historic performance data can be used to validate a system model. At block 714, the system model can be validated using testing data. Testing data can be data obtained in a testing of the unit corresponding to the system model. In some cases, the data can be data from a similar unit that can be used to validate aspects of the performance or behavior of the system model. In some cases, testing data can comprise data obtained from individual components (e.g., pumps, fans, heat exchangers, etc.). Validating the system model can comprise comparing an output from the system model (e.g., given particular inputs and environmental conditions) and a value from the historical data.

For example, with reference to FIG. 5, a system model can include a model for a heat exchanger, and validating the system model can include comparing an outlet air temperature (pT) of the system model to an outlet air temperature from the historical data under the same or similar conditions (e.g., given the same inputs). In some cases, if an output of the system model differs from the historical data by a threshold amount (e.g., is outside of a margin of error), the system model can be revised. In some cases, revising a system model can include performing a training operation (e.g., an artificial intelligence training operation) for the system model. In an example, training the system model can include adding one or more convolutional layers to the system model (e.g., upstream or downstream of the physics-based model) to transform an output to provide more accurate predictions of a system behavior (e.g., an output that is closer to the outputs of the historical data at block 708).

In some cases, additional models can be developed for a cooling unit or cooling infrastructure of a data center. For example, a three-dimensional geometry for the cooling unit (e.g., the CDU or HRU 102 shown in FIG. 1) can be developed at block 706. The three-dimensional geometry can be defined in a CAD file including three-dimensional renderings of the cooling unit and components of the cooling unit. In some cases, the CAD file can include material properties of components, information about physical interfaces (e.g., fasteners, welded connections, hinged arrangements, quick-connect fittings, movable handles for valves, etc.). The 3D model can be used at block 710 to develop models for a physical performance of the cooling unit. For example, at block 710, computational flow dynamics (CFD), finite element analysis (FEA), and vibration models can be developed based on the 3D geometry of the cooling unit (e.g., as defined in the CAD file).

In some cases, a complexity of models (e.g., physics-based models and artificial intelligence models) can consume a large amount of computational resources and in some cases, can require hours or days to perform simulations. At block 712, reduced order models can be provided for the CFD, FEA, and vibration models. In some cases, a reduced order model can include a linearization of complex model. In some cases, reduced order models can be developed for any of the models discussed herein. Reduced order models can be trained and validated on the historical data from block 708. Training a reduced order model can include testing a significance of inputs (e.g., features) in producing an output, and pruning inputs that increase a computational complexity of the model without producing an increased accuracy for the model. In some cases, reduced order models can be tested and refined using a training data set of the data from block 708, and can be validated on a validation data set of the data from block 708.

At block 716, the models (e.g., the validated system model of block 704, and the reduced order models of block 712) can be incorporated into a digital twin (e.g., any of digital twins 104, 608 shown in FIGS. 1 and 6). Incorporating the models into a digital twin can include preparing a software package including the models in a unified application. In some cases, the digital twin can comprise one or more software modules (e.g., packages, containers, libraries, collections of files, etc.). The software modules can be installable onto a computer system (e.g., computer system 106 shown in FIG. 1), and can provide an application engageable by an operator or other computer systems (e.g., via an API, a web interface, a CLI, etc.).

At block 718, the digital twin can be deployed for use in production environments. Deploying a digital twin can include installing the software modules of the digital twin onto one or more computing systems (e.g., computer system 106 shown in FIG. 1) that are accessible (e.g., via a networked or wired connection) to an operator (e.g., via computer system 110 shown in FIG. 1) or cooling units (e.g., CDU or HRU 102 shown in FIG. 1) corresponding to the digital model.

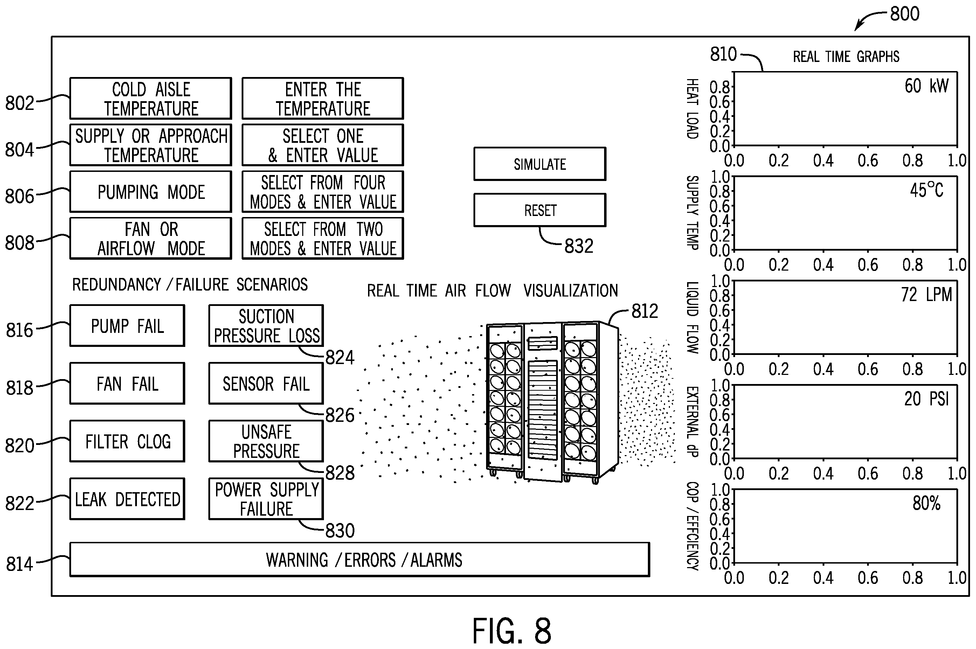

FIG. 8 illustrates an example user interface (UI) 800 for operating a digital twin of a CDU or HRU. A user may access the UI 800 remotely or manually via a data center infrastructure management (DCIM) software. For example, the UI 800 may be accessed using an application programming interface, command line interface, web interface, or the like running DCIM software. The UI 800 may receive input from a user and generate corresponding outputs in real-time. For example, a user may input a cold aisle temperature 802 (i.e., an inlet temperature) and/or a supply or approach temperature 804. For example, the supply temperature may be a temperature of a liquid supplied to a rack of a heat exchanger. In another example, the supply temperature may be calculated by a system associated with the UI 800 by summing the received cold aisle temperature 802 and the approach temperature. The inputs and outputs utilized by the UI 800 may be displayed using imperial or metric units.

The user interface may further input a pumping mode 806. For example, the pumping mode 806 may be selected from the four pump modes described above: manual mode, liquid flow mode, external pressure mode, and temperature differential mode displayed on the UI 800. In some examples, the user may select a fan mode 808. For example, the fan mode 808 may be selected from the two fan modes described above: a manual mode or a supply temperature mode. Based on which mode is selected, the UI 800 may further prompt a user to provide a corresponding value, such as a speed of the pump, a liquid flow rate, a pressure, a temperature differential, a supply temp, or the like. In some examples, the user may input the corresponding value(s) by manually typing in a value, or selecting a value from a sliding scale

As further illustrated in FIG. 8, the UI 800 may produce one or more graphs 810, displaying various outputs based on the inputs received by the user. In some examples, the x-axis of the graphs 810 may represent time (e.g., in seconds) versus output data points, such as load, supply temperature, liquid flow rate, external pressure, efficiency, or the like. The graphs 810 may allow a user to visualize how output values may be affected by inputs and PID loops of the virtual model. As illustrated in FIG. 8, each graph 810 may display a text box indicating a current parameter value. A three dimensional image 812 of a CDU or HRU may be displayed on the UI 800. The image 812 may provide a real-time simulation of the CDU or HRU corresponding air flows. For example, the image 812 may display the transition of cold air into hot air, as well as any turbulence that is produced, based on the received inputs and operating parameters.

In some examples, the UI 800 may display a status bar 814. The status bar 814 indicates a status of the CDU or HRU virtual model based on received inputs and operating parameters. In some examples, the status bar 814 may display no status, indicating that the CDU or HRU is operating under normal conditions, or may indicate a failure type. For example, a user may select, using one or more buttons displayed on the UI 800, a type of failure to simulate on the virtual model using UI 800. For example, the UI 800 may display buttons for pump failure, a fan failure, a filter clog, a detected leak, a loss of suction pressure, a sensor failure, an over-pressure, and a power supply failure.

In some examples, when a user selects the pump failure button 816, the UI 800 may simulate a scenario of a pump failing. For example, if the CDU or HRU contains two pumps, the failure of one pump may trigger a switchover event to the other pump, resulting in flow rate and pressure drops, which may be displayed by the graphs 810. If a user selects the fan failure button 818, the UI 800 may cause the virtual model to simulate an operation of the CDU or HRU with one fan failing to operate. For example, the CDU or HRU may include 14 fans, therefore, when the fan failure 818 is selected, the UI 800 may display conditions corresponding to 13 fans operating. In some examples, the CDU or HRU may include one or more leak detection cables. When a user selects the leak detection button 822, the UI 800 may simulate a process of shutting down the CDU or HRU, which occurs when the one or more leak detection cables detect a loss of suction pressure of liquid. During some simulated failure scenarios, the functionality and operation of the CDU or HRU may be unaffected. For example, when a user selects the clogged filter button 820 , the sensor failure button 826, or the power supply failure button 830, the simulation may be unchanged, due to the redundancy of components within the CDU or HRU.

In some examples, the failure scenario options displayed in FIG. 8 are used to replicate various behaviors of a CDU or HRU during conditions corresponding to each scenario. During these conditions, one or more alarms may be triggered. The alarms may indicate a type of failure, such as a minor failure, a major failure, or a critical failure. The UI 800 may indicate that the CDU or HRU has shut down based on the level of failure. As illustrated in FIG. 8, the UI 800 may include a reset button 832, which a user may select to start a new simulation.

In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, a method of otherwise implementing such capabilities, a method of manufacturing relevant components of such a device or system (or the device or system as a whole), and a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the invention, of the utilized features and implemented capabilities of such device or system.

### FURTHER EXAMPLES

Example 1. A system for optimizing operation of a coolant distribution unit (CDU), comprising: a CDU to cool electrical equipment in a data center, the CDU having a pump, a fan, a heat exchanger, and a sensor monitoring operational data of the CDU; a computing system, the computing system receiving real-time operational data from the sensor of the CDU and generating optimized configuration parameters for the CDU based on real-time operational data from the sensor; a digital twin of the CDU, the digital twin hosted on the computing system, the digital twin including a physics-based model and an artificial intelligence model used to simulate thermal behavior of the CDU based on the real-time operational date from the sensor, the artificial intelligence model being trained on historical operational data from the sensor of the CDU; and a user interface for interacting with the digital twin, the user interface hosted on the computing system.

Example 2. The system of Example 1, wherein the physics-based model includes at least one of a stress model, a vibration model, a thermal model, a data-driven model, or a reliability model.

Example 3. The system of Example 1 or Example 2, wherein the digital twin receives operational data from the CDU and updates the physics-based model based on the operational data.

Example 4. The system of any one of Examples 1 to 3, wherein the user interface receives input values for operating parameters of the CDU and generates outputs based on the input values using the digital twin.

Example 5. The system of Example 4, wherein the outputs include at least one of predicted system parameters, failure conditions, or optimized configurations for the CDU.

Example 6. The system of Example 5, wherein the digital twin generates an optimization strategy for the CDU based on the optimized configurations.

Example 7. The system of any one of Examples 1 to 6, wherein the CDU is one of a liquid-to-air CDU, a liquid-to-liquid CDU, an air-to-liquid CDU, a rear-door CDU, or an in-rack CDU.

Example 8. A method for optimizing operation of a coolant distribution unit (CDU) in a data center, the method comprising: providing a CDU including a pump, a fan, a heat exchanger, and a sensor monitoring operational data of the CDU; receiving, at a digital twin of the CDU, real-time operational data from the sensor of the CDU, the operational data including temperature data, pressure data, and flow rate data; simulating, using a plurality of physics-based models and at least one artificial intelligence model of the digital twin, thermal behavior of the CDU based on the real-time operational data; and generating, based on the simulated behavior, control parameters for at least one of the pump or the fan to optimize cooling efficiency of the CDU.

Example 9. The method of Example 8, wherein the digital twin includes a plurality of models to simulate behavior of the CDU, the plurality of models including at least one of a stress model, a vibration model, a thermal model, a data-driven model, or a reliability model.

Example 10. The method of Example 8 or Example 9, further comprising: receiving operational data from the sensor of the CDU and updating one or more models of the digital twin based on the operational data.

Example 11. The method of any one of Examples 8 to 10, further comprising: displaying, via a user interface, a three-dimensional image of the CDU that provides a real-time simulation of air flow within the CDU based on the real-time operational data.

Example 12. The method of any one of Examples 8 to 11, further comprising: displaying, via a user interface, an operational status of the CDU; and displaying, via the user interface, an alert corresponding to detected or simulated failure conditions.

Example 13. The method of any one of Examples 8 to 12, further comprising: displaying, via a user interface, selectable failure scenario options that, when selected, cause the digital twin to simulate behavior of the CDU under the selected failure scenario and display corresponding changes to operational parameters.

Example 14. The method of Example 13, wherein the selectable failure scenario options include at least one of pump failure, fan failure, filter clog, detected leak, loss of suction pressure, sensor failure, over-pressure, or power supply failure.

Example 15. The method of any one of Examples 8 to 14, wherein the CDU is one of a liquid-to-air CDU, a liquid-to-liquid CDU, an air-to-liquid CDU, a rear-door CDU, or an in-rack CDU.

Example 16. A system for optimizing operation of a coolant distribution unit (CDU), comprising: a CDU to cool electrical equipment in a data center, the CDU including a pump, a fan, and a heat exchanger; a digital twin of the CDU, the digital twin including a plurality of physics-based models and at least one artificial intelligence model used to simulate thermal behavior of the CDU, the artificial intelligence model being trained on historical operational data from the CDU; and a computing system hosting the digital twin and providing a user interface for interacting with the digital twin, the computing system to: receive real-time operational data from the CDU; generate, using the digital twin, simulated behavior of the CDU based on the real-time operational data; and display, via the user interface, the simulated behavior of the CDU.

Example 17. The system of Example 16, wherein the plurality of physics-based models includes at least one of a stress model, a vibration model, a thermal model, a data-driven model, or a reliability model.

Example 18. The system of Example 16 or Example 17, wherein the user interface displays a plurality of graphs showing real-time changes in output values including at least one of load, supply temperature, liquid flow rate, external pressure, or efficiency based on the simulated behavior.

Example 19. The system of any one of Examples 16 to 18, wherein the user interface displays a three-dimensional image of the CDU that provides a real-time simulation of air flow within the CDU based on the real-time operational data.

Example 20. The system of any one of Examples 16 to 19, wherein the user interface displays selectable failure scenario options that, when selected, cause the digital twin to simulate behavior of the CDU under the selected failure scenario.

Also as used herein, unless otherwise limited or specified, "substantially identical" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Features of the devices and systems described may be incorporated into/used in corresponding methods and vice versa.

The previous description of the disclosed embodiments is provided to enable any person skilled in the art to make or use the invention. Various modifications to these embodiments will be readily apparent to those skilled in the art, and the generic principles defined herein may be applied to other embodiments without departing from the spirit or scope of the invention. Thus, the invention is not intended to be limited to the embodiments shown herein but is to be accorded the widest scope consistent with the principles and novel features disclosed herein.

## Claims

1. A system for optimizing operation of a coolant distribution unit (CDU), comprising:
a CDU to cool electrical equipment in a data center, the CDU having a pump, a fan, a heat exchanger, and a sensor monitoring operational data of the CDU;
a computing system, the computing system receiving real-time operational data from the sensor of the CDU and generating optimized configuration parameters for the CDU based on real-time operational data from the sensor;
a digital twin of the CDU, the digital twin hosted on the computing system, the digital twin including a physics-based model and an artificial intelligence model used to simulate thermal behavior of the CDU based on the real-time operational date from the sensor, the artificial intelligence model being trained on historical operational data from the sensor of the CDU; and
a user interface for interacting with the digital twin, the user interface hosted on the computing system.

2. The system of claim 1, wherein the physics-based model includes at least one of a stress model, a vibration model, a thermal model, a data-driven model, or a reliability model.

3. The system of claim 1 or claim 2, wherein the digital twin receives operational data from the CDU and updates the physics-based model based on the operational data.

4. The system of claim 1, claim 2 or claim 3, wherein the user interface receives input values for operating parameters of the CDU and generates outputs based on the input values using the digital twin.

5. The system of claim 4, wherein the outputs include at least one of predicted system parameters, failure conditions, or optimized configurations for the CDU.

6. The system of claim 5, wherein the digital twin generates an optimization strategy for the CDU based on the optimized configurations.

7. The system of claim 1 or of any of claims 2 to 6, wherein the CDU is one of a liquid-to-air CDU, a liquid-to-liquid CDU, an air-to-liquid CDU, a rear-door CDU, or an in-rack CDU.

8. A method for optimizing operation of a coolant distribution unit (CDU) in a data center, the method comprising:
providing a CDU including a pump, a fan, a heat exchanger, and a sensor monitoring operational data of the CDU;
receiving, at a digital twin of the CDU, real-time operational data from the sensor of the CDU, the operational data including temperature data, pressure data, and flow rate data;
simulating, using a plurality of physics-based models and at least one artificial intelligence model of the digital twin, thermal behavior of the CDU based on the real-time operational data; and
generating, based on the simulated behavior, control parameters for at least one of the pump or the fan to optimize cooling efficiency of the CDU.

9. The method of claim 8, wherein the digital twin includes a plurality of models to simulate behavior of the CDU, the plurality of models including at least one of a stress model, a vibration model, a thermal model, a data-driven model, or a reliability model.

10. The method of claim 8 or claim 9, further comprising:
receiving operational data from the sensor of the CDU and updating one or more models of the digital twin based on the operational data.

11. The method of claim 8, claim 9 or claim 10, further comprising:
displaying, via a user interface, a three-dimensional image of the CDU that provides a real-time simulation of air flow within the CDU based on the real-time operational data.

12. The method of claim 8 or of any of claims 9 to 11, further comprising:
displaying, via a user interface, an operational status of the CDU; and
displaying, via the user interface, an alert corresponding to detected or simulated failure conditions.

13. The method of claim 8 or of any of claims 9 to 12, further comprising:
displaying, via a user interface, selectable failure scenario options that, when selected, cause the digital twin to simulate behavior of the CDU under the selected failure scenario and display corresponding changes to operational parameters.

14. The method of claim 13, wherein the selectable failure scenario options include at least one of pump failure, fan failure, filter clog, detected leak, loss of suction pressure, sensor failure, over-pressure, or power supply failure.

15. The method of claim 8 or of any of claims 9 to 14, wherein the CDU is one of a liquid-to-air CDU, a liquid-to-liquid CDU, an air-to-liquid CDU, a rear-door CDU, or an in-rack CDU.
